Europäisches Patentamt

(19) European Patent Office

Office européen des brevets

(11) Publication number: **0 070 175**
**B1**

(12) **EUROPEAN PATENT SPECIFICATION**

(45) Date of publication of patent specification: **04.03.87**

(51) Int. Cl.⁴: **H 03 M 1/14,** H 03 M 1/34

(21) Application number: **82303629.8**

(22) Date of filing: **09.07.82**

(54) **Analog-to-digital converters.**

(30) Priority: **10.07.81 JP 107656/81**

(43) Date of publication of application:
**19.01.83 Bulletin 83/03**

(45) Publication of the grant of the patent:
**04.03.87 Bulletin 87/10**

(84) Designated Contracting States:
**AT DE FR GB NL**

(56) References cited:
**FR-A-2 454 229**
**FR-A-2 458 178**
**US-A-3 935 569**

**ELECTRONIC ENGINEERING, vol. 48, no. 585,
November 1976, pages 28-29, London, GB R.W.
HARTLEY: "Special purpose analogue to digital
converter"**

(73) Proprietor: **SONY CORPORATION**
**7-35 Kitashinagawa 6-Chome Shinagawa-ku
Tokyo 141 (JP)**

(72) Inventor: **Yamada, Takaaki
4-6-1 Iriya
Zama-shi Kanagawa-ken (JP)**
Inventor: **Sekino, Takeo
3-1-3-402 Tobio
Atsugi-shi Kanagawa-ken (JP)**

(74) Representative: **Thomas, Christopher Hugo
et al
D Young & Co 10 Staple Inn
London WC1V 7RD (GB)**

# Description

This invention relates to analog-to-digital converters.

Analog-to-digital converters are known which can be classified as either parallel-type converters or serial-to-parallel type converters.

Parallel-type analog-to-digital converters which produce n bit digital outputs, generally require $(2^n-1)$ voltage comparison circuits (comparators) connected in parallel. An analog input voltage is supplied to the $(2^n-1)$ voltage comparators, and the outputs from the voltage comparators are supplied to an encoder which then produces the n-digit output.

In a serial-to-parallel type analog-to-digital converter having an output of m more significant bits and n less significant bits, the input voltage is supplied to a first stage of $(2^m-1)$ voltage comparison circuits (comparators), just as in the parallel-type analog-to-digital converter, to generate the m more significant bits. The m more significant bits are then supplied to a digital-to-analog converter and reconverted to an analog voltage. The reconverted analog voltage is then subtracted from the analog input voltage and the difference is supplied to a second stage of $(2^n-1)$ voltage comparators to derive the n less significant bits.

In the parallel-type analog-to-digital converter, $(2^n-1)$ voltage comparators are required when the analog input voltage is converted to a digital output of n bits. A large number of circuits elements are required for such an analog-to-digital converter, and the resulting integrated circuit is large and has a correspondingly large power consumption.

In the serial-to-parallel analog-to-digital converter, only $(2^m+2^n-2)$ voltage comparators are used when the output has $m+n$ bits. The chip size and power consumption are reduced as compared with the parallel-type analog-to-digital converter. However, a serial-to-parallel analog-to-digital converter requires a digital-to-analog converter. If an error occurs between the first and second stages of the converter, the error is repeated in the digital output. For example, with a monotonically increasing voltage $V_{in}$, if an error occurs between the first and second stages so that the output from the first stage is reduced, the digital output from the second stage will be reduced, and the digital output of the converter will not increase monotonically.

US patent specification US—A—3 935 569 discloses an analog-to-digital converter having the features set out in the pre-characterising part of claim 1 of the present application.

According to the present invention there is provided an analog-to-digital converter for converting an analog input voltage to a digital output voltage signal of m more significant bits and n less significant bits, the converter comprising:

a plurality of resistors connected in a series circuit to a voltage source for establishing respective reference voltages;

more and less significant bit comparators for comparing said reference voltages with said analog input voltage to provide respective outputs encoded as said more significant and less significant bits of the digital output voltage signal, said more significant bit comparators having first inputs all receiving said analog input voltage and second inputs connected to said series circuit at respective intervals defining groups of said resistors therebetween, the outputs of said more significant bit comparators being encoded as said more significant bits of the digital output voltage signal in a more significant bit encoder; and

said less significant bit comparators having first inputs also all receiving said analog input voltage and second inputs connected to said groups of resistors, said outputs of said less significant bit comparators being supplied to a less significant bit encoder for encoding as said less significant bits of the digital output voltage signal;

characterised by:

switch elements arranged in groups, said switch elements in each group having first terminals connected to respective points between the resistors of a corresponding one of said groups of resistors and second terminals connected to the second inputs of respective ones of said less significant bit comparators; and

said more significant bit encoder further generating switch control signals which actuate said switch elements of a selected said group of the switch elements to be conductive, the switch elements of the other said groups of switch elements then being non-conductive, the actuated said group of the switch elements being selected in dependence on the values of said more significant bits.

The invention will now be described by way of example with reference to the accompanying drawings, in which:

Figure 1 is a block diagram of a prior art parallel-type analog-to-digital converter;

Figure 2 is a block diagram of a prior art serial-to-parallel analog-to-digital converter;

Figure 3A is a block diagram of an embodiment of analog-to-digital converter according to the invention;

Figures 3B and 3C are partial block diagrams illustrating the operation of the analog-to-digital converter of Figure 3A; and

Figures 4 and 5 are truth tables of encoders in the embodiment of Figure 3A.

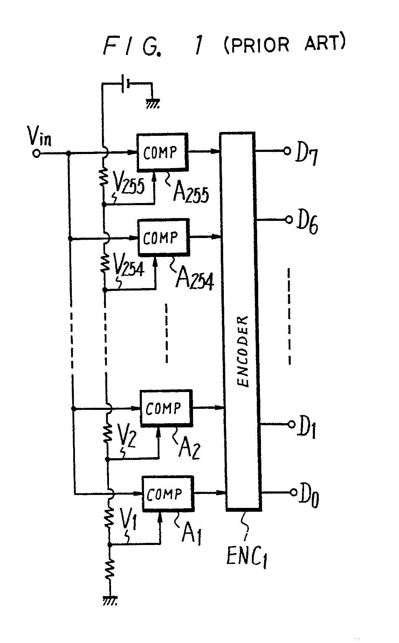

Referring initially to Figure 1, a prior art parallel-type analog-to-digital converter is shown in which an analog input voltage $V_{in}$ is converted to an $n=8$ bit digital output $D_0$ to $D_7$. The parallel-type analog-to-digital converter of Figure 1 has 255, that is $2^8-1$, voltage comparison circuits (comparators) $A_1$ to $A_{255}$, providing 255 reference voltage steps $V_1$ to $V_{255}$. The analog input voltage $V_{in}$ is compared with each of the reference voltages $V_1$ to $V_{255}$, and outputs from the voltage comparators $A_1$ to $A_{255}$ are supplied to an encoder $ENC_1$ which generates the digital outputs $D_0$ to $D_7$.

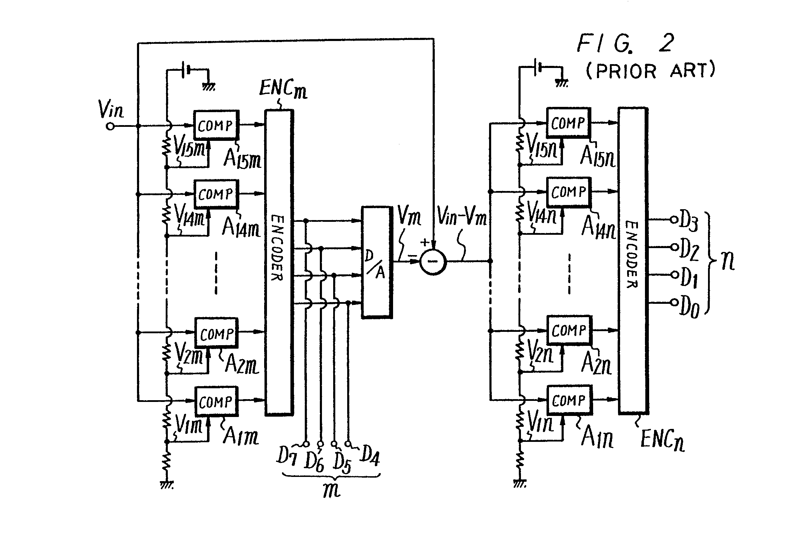

In Figure 2, a prior art serial-to-parallel type analog-to-digital converter is shown in which an analog input voltage $V_{in}$ is converted to a digital output voltage of $n=4$ less significant bits and $m=4$ more significant bits. The $n$ less significant bits are denoted as digital outputs $D_0$ to $D_3$, while the $m$ more significant bits are denoted as digital outputs $D_4$ to $D_7$. The input voltage $V_{in}$ is supplied to a first stage of the serial-to-parallel type analog-to-digital converter having 15, that is $2^4-1$, voltage comparison circuits (comparators) $A_{1m}$ to $A_{15m}$ and corresponding voltage steps $V_{1m}$ to $V_{15m}$, from which digital outputs are supplied to a first encoder $ENC_m$, from which the digital outputs $D_4$ to $D_7$ are derived. The digital outputs $D_4$ to $D_7$ are supplied to a digital-to-analog converter where they are reconverted to an analog voltage $V_m$. The analog voltage $V_m$ is then subtracted from the input voltage $V_{in}$, and the difference is supplied to a second stage of the serial-to-parallel type analog-to-digital converter. The second stage has 15, that is $2^4-1$, voltage comparison circuits $A_{1n}$ to $A_{15n}$ and corresponding voltage steps $V_{1n}$ to $V_{15n}$, and supplies outputs to a second encoder $ENC_n$, which generates the $n$ less significant bits digital outputs $D_0$ to $D_3$.

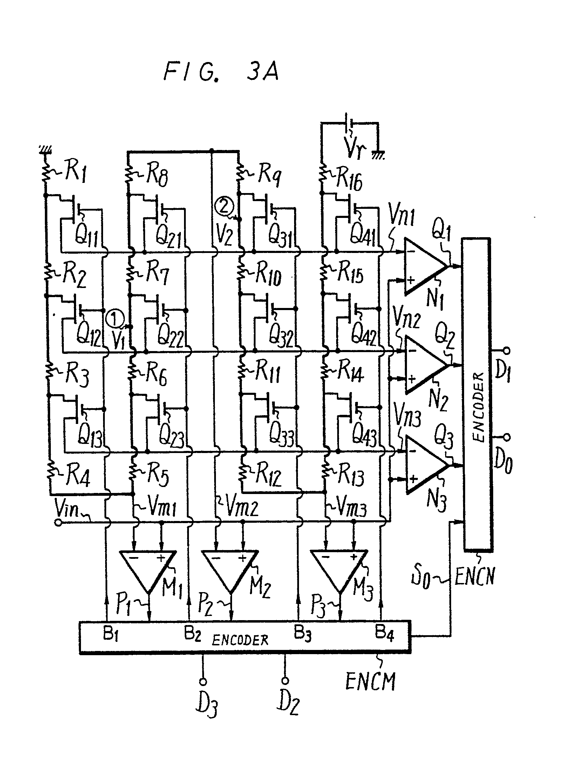

Referring now to Figure 3A, it will be seen that, in an embodiment of analog-to-digital converter according to the invention there illustrated, an analog input voltage $V_{in}$ is supplied to first or positive inputs of three voltage comparators $M_1$ to $M_3$ for determining a more significant bit digital voltage, and three voltage comparators $N_1$ to $N_3$ for determining a less significant bit digital voltage. Resistors $R_1$ to $R_{16}$ are connected in series between a reference voltage supply source $V_r$ and ground. The resistors $R_1$ to $R_4$, $R_5$ to $R_8$, $R_9$ to $R_{12}$, and $R_{13}$ to $R_{16}$ are arranged in groups of four resistors, with each group providing four reference voltage steps. The comparator $M_1$ has its second or negative input connected between the resistors $R_4$ and $R_5$ and is supplied with a voltage $V_{m1}$. The comparator $M_2$ has its second or negative input connected between the resistors $R_8$ and $R_9$ and is supplied with the voltage $V_{m2}$. The comparator $M_3$ has its second or negative input connected between the resistors $R_{12}$ and $R_{13}$ and is supplied with the voltage $V_{m3}$.

Switch elements, preferably in the form of metal oxide semiconductor field effect transistors (MOS-FETs) $Q_{11}$, $Q_{21}$, $Q_{31}$ and $Q_{41}$ have their sources connected to the series resistor circuit between the resistors $R_1$ and $R_2$, $R_7$ and $R_8$, $R_9$ and $R_{10}$, and $R_{15}$ and $R_{16}$, respectively, and their drains connected to a second or negative input terminal of the comparator $N_1$. Switch elements formed by MOS-FETs $Q_{12}$, $Q_{22}$, $Q_{32}$ and $Q_{42}$ are similarly connected between the resistors $R_2$ and $R_3$, $R_6$ and $R_7$, $R_{10}$ and $R_{11}$, and $R_{14}$ and $R_{15}$ and a second or negative input terminal of the comparator $N_2$. Switch elements formed by MOS-FETs $Q_{13}$, $Q_{23}$, $Q_{33}$ and $Q_{43}$ are similarly connected between the resistors $R_3$ and $R_4$, $R_5$ and $R_6$, $R_{11}$ and $R_{12}$, and $R_{13}$ and $R_{14}$ and a second or negative input terminal of the comparator $N_3$.

The comparators $M_1$, $M_2$ and $M_3$ generate out-

put signals $P_1$, $P_2$ and $P_3$ indicative of the more significant bits of the digital output voltage. The outputs $P_1$, $P_2$ and $P_3$ are supplied to an encoder ENCM from which more significant bit digital outputs $D_2$ and $D_3$ are derived. The more significant bit encoder ENCM also selectively generates control signals $B_1$ to $B_4$ which are supplied to the gates of respective MOS-FETs $Q_{11}$ to $Q_{13}$, $Q_{21}$ to $Q_{23}$, $Q_{31}$ to $Q_{33}$, and $Q_{41}$ to $Q_{43}$, respectively. In addition, the more significant bit encoder ENCM generates a second control signal $S_0$, whose function will be described below.

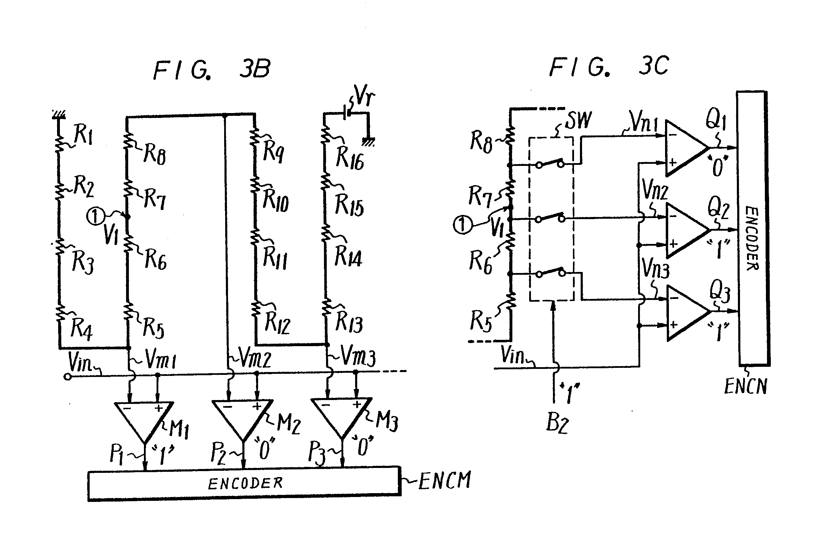

The control signals $B_1$ to $B_4$ from the encoder ENCM selectively actuate the MOS-FETs $Q_{11}$ to $Q_{13}$, $Q_{21}$ to $Q_{23}$, $Q_{31}$ to $Q_{33}$, and $Q_{41}$ to $Q_{43}$, respectively, to supply voltages $V_{n1}$, $V_{n2}$ and $V_{n3}$ to the negative input terminals of the comparators $N_1$, $N_2$ and $N_3$, as shown in Figures 3A and 3C, which generate outputs $Q_1$, $Q_2$ and $Q_3$ supplied to a less significant bit encoder ENCN. The encoder ENCN generates less significant bit digital outputs $D_0$ and $D_1$ from the outputs $Q_1$, $Q_2$ and $Q_3$ and the control signal $S_0$ supplied from the more significant bit encoder ENCM.

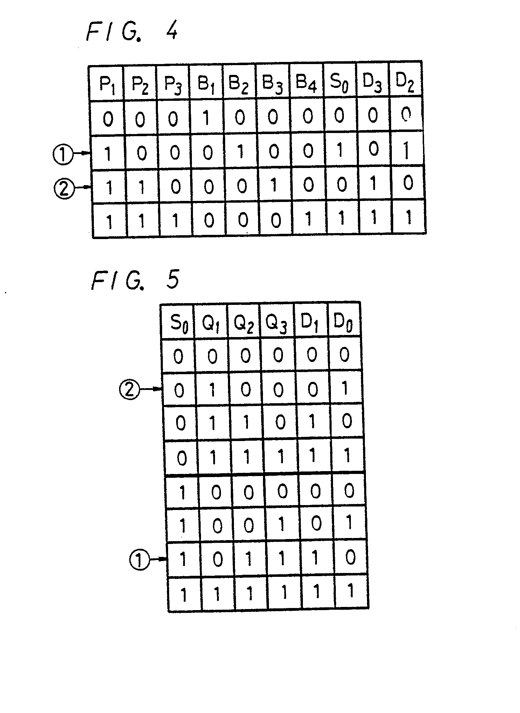

Figure 4 illustrates the truth table for the encoder ENCM, while Figure 5 illustrates the truth table for the encoder ENCN. The table of Figure 4 indicates the outputs $B_1$ to $B_4$, $S_0$, $D_3$ and $D_2$ for given input signals $P_1$ to $P_3$. The table of Figure 5 indicates the outputs $D_1$ and $D_0$ for given input signals $S_0$, $Q_1$, $Q_2$ and $Q_3$.

The operation of the embodiment will now be described with reference to Figures 3A, 3B and 3C. If the analog input voltage $V_{in}$ is equal to a reference electric potential $V_1$ at a connection point between the resistors $R_6$ and $R_7$, as denoted by reference point ① in Figure 3A, then the analog input voltage $V_{in}$ is greater than $V_{m1}$, but less than $V_{m2}$ and $V_{m3}$. The output $P_1$, representing a comparison between $V_{in}$ and $V_{m1}$, is equal to "1". The output $P_2$, representing a comparison between $V_{in}$ and $V_{m2}$, is equal to "0", since $V_{in}$ is less than $V_{m2}$. The output $P_3$ is equal to "0", as $V_{in}$ is less than $V_{m3}$. Reading across the second row of the truth table of Figure 4, the bit $D_3$ is equal to "0" and the bit $D_2$ is equal to "1".

Figure 3B illustrates the circuit of Figure 3A from which the MOS-FETs $Q_{11}$ to $Q_{43}$, the comparators $N_1$ to $N_3$, and the encoder ENCN have been eliminated for clarity. The outputs $P_1$, $P_2$ and $P_3$ are also indicated as "1", "0" and "0", respectively.

Referring to the second row of the truth table of Figure 4, the control signal $B_1$ is equal to "0", the control signal $B_2$ is equal to "1", the control signal $B_3$ is equal to "0", and the control signal $B_4$ is equal to "0". Accordingly, the MOS-FETs $Q_{21}$, $Q_{22}$ and $Q_{23}$, indicated in Figure 3C as a switch assembly SW, are turned on to allow the electric potentials at the respective connection points between the adjacent resistors $R_8$ and $R_7$, $R_7$ and $R_6$, and $R_6$ and $R_5$, respectively, to be supplied to the comparators $N_1$, $N_2$ and $N_3$ as voltages $V_{n1}$, $V_{n2}$ and $V_{n3}$. Since the input voltage $V_{in}$ is equal to the electric potential $V_1$ at the point ①, the analog

input voltage $V_{in}$ is less than the reference voltage $V_{n1}$, is equal to the reference voltage $V_{n2}$, and is greater than the reference voltage $V_{n3}$. Accordingly, $Q_1$ is equal to "0", $Q_2$ is equal to "1", and $Q_3$ is equal to "1". Reading across the seventh row of the truth table of Figure 5, with $S_0$ equal to "1", the bit $D_1$ is equal to "1" and the bit $D_0$ is equal to "0".

When the analog input voltage $V_{in}$ is equal to the electric potential $V_1$ at the point ①, the digital outputs $D_3$ to $D_0$ become "0110". The electric potential at the point ① is the electric potential of the sixth step, counting from the ground side, where the ground electric potential is numbered as step zero. The decimal number six is binary number "0110", so the digital output "0110" is correct.

By way of a second example, if the analog input voltage $V_{in}$ is equal to an electric potential $V_2$ at the connection point between the resistors $R_9$ and $R_{10}$, as shown, for example, at a point ② in Figure 3A, the electric potential $V_2$ at the point ② is greater than $V_{m1}$ and $V_{m2}$, but less than $V_{m3}$. Accordingly, the output $P_1$ is equal to "0". Reading across the third row of the truth table of Figure 4, the bit $D_3$ is equal to "1" and the bit $D_2$ is equal to "0".

The truth table of Figure 4 also indicates that the control signal $B_1$ is equal to "0", the control signal $B_2$ is equal to "0", the control signal $B_3$ is equal to "1", and the control signal $B_4$ is equal to "0". Accordingly, only the MOS-FETs $Q_{31}$, $Q_{32}$ and $Q_{33}$ are turned on to supply electric potentials at the respective connection points between adjacent resistors $R_9$ to $R_{12}$ to the comparators $N_1$, $N_2$, $N_3$. Since the input voltage $V_{in}$ is the same as the electric potential $V_2$ at the point ②, the analog input voltage $V_{in}$ is equal to the reference voltage $V_{n1}$, but is less than the reference voltages $V_{n2}$ and $V_{n3}$. $Q_1$ is equal to "1", $Q_2$ is equal to "0", and $Q_3$ is equal to "0". From the truth table of Figure 4, $S_0$ is equal to "0". The truth table of Figure 5 indicates in the second row that the bit $D_1$ is equal to "0", and the bit $D_0$ is equal to "1".

When the analog input voltage $V_{in}$ is equal to the electric potential $V_2$, the digital outputs $D_3$ to $D_0$ become "1001". The electric potential $V_2$ at the point ② is the electric potential of the ninth step, counting from the ground side. The decimal number nine is binary number "1001", indicating that the digital output "1001" is correct.

In the illustrated embodiment of the invention, the voltage derived from each of the four groups of resistors into which the resistors $R_1$ to $R_{16}$ are divided, is compared with the analog input voltage $V_{in}$ to derive more significant bits $D_3$ and $D_2$ of the digital output and to select one of the resistor groups. The voltage derived from each resistor of the selected group is compared with the analog input voltage $V_{in}$ to derive the less significant bits $D_1$ and $D_0$ of the digital output. If there are m more significant bits and n less significant bits of digital output required, the illustrated embodiment utilizes $2^m-1$ more significant bit voltage comparators and $2^n-1$ less significant bit voltage comparators. This embodiment thus has far fewer comparison circuits than the prior art analog-to-digital converter of Figure 1 which, for m+n bits of output, would require $(2^{m+n}-1)$ comparators. Embodiments of analog-to-digital converter in accordance with the invention can also be produced on a smaller chip, which uses lesser amounts of power than the prior art devices.

Embodiments of analog-to-digital converter in accordance with the invention also eliminate the digital-to-analog converter required by the serial-to-parallel analog-to-digital converter of Figure 2, and any errors which may result therefrom.

When an embodiment of analog-to-digital converter according to the invention is an integrated circuit, the resistors $R_1$ to $R_{16}$ can be formed in a zig-zag line on the chip. The resistors $R_1$ to $R_{16}$ occupy only small areas on the chip, so temperature variations have minimal effects upon the circuit elements, thereby contributing to a precision circuit.

When the circuit elements are formed as shown in Figure 3A, the semiconductor chip is compact. In a preferred embodiment of the invention, a very compact circuit is produced when the bit ratio of the more and less significant bits is 1, as for example, a bit ratio of 4:4.

When an analog-to-digital converter is formed with the resistors $R_1$ to $R_{16}$ in a zig-zag pattern, the reference voltage increases from top to bottom, as shown in Figure 3A, the resistor strings $R_1$ to $R_4$ and $R_9$ to $R_{12}$ (hereinafter referred to as group A), and decreases from top to bottom in the resistor strings $R_5$ to $R_8$ and $R_{13}$ to $R_{16}$ (hereinafter referred to as group B). Since the reference bias conditions of the resistor strings of group A differ from those of the resistor strings of group B, the voltage comparators $N_1$, $N_2$ and $N_3$ should accordingly be interchanged when the different groups are connected by the respective switch assemblies SW. In the illustrated embodiment, the outputs $Q_1$, $Q_2$, and $Q_3$ of the comparators $N_1$, $N_2$ and $N_3$ are inverted in response to the control signal $S_0$ from the upper bit encoder ENCM, rather than physically interchanging the comparators $N_1$, $N_2$ and $N_3$. For example, if the outputs $Q_1$, $Q_2$ and $Q_3$ equal "1", "0" and "0", they are inverted to be equal to "0", "1", "1" respectively.

In the above second example in which the analog input voltage $V_{in}$ is equal to an electric potential $V_2$ at the connection point between the resistors $R_9$ and $R_{10}$, as shown at the point ② in Figure 3A, as described above, the more significant bit encoder ENCM will generate the control signal $B_3$ equal to "1" to couple the resistor string $R_9$ to $R_{12}$ to the comparators $N_1$, $N_2$ and $N_3$. The outputs $Q_1$, $Q_2$ and $Q_3$ of the comparators $N_1$, $N_2$ and $N_3$ will be equal to "1", "0" and "0", respectively.

However, in the second example, the distance on the integrated circuit chip from the resistor $R_9$ to the point ② is the same as the distance from the resistor $R_8$ to the point ① of the first example, and the voltage differences are the same. Accordingly, the outputs $Q_1$, $Q_2$ and $Q_3$, which are equal

to "1", "0" and "0", must be inverted to be equal to "0", "1" and "1". The more significant bit encoder ENCM generates the control signal $S_0$ to effect the required inversion.

Since the reference voltages derived from the resistors $R_1$ to $R_{16}$ are used to generate digital outputs $D_2$ to $D_0$, a monotonic change in the input voltage $V_{in}$ has a corresponding monotonic change in the digital outputs $D_3$ to $D_0$.

In the embodiment of Figure 3, the resistor $R_{16}$ can be eliminated, and the embodiment will function as hereinbefore described.

The analog-to-digital converter of the present invention is not limited to the 4-bit analog-to-digital converter of the illustrative embodiment, but can also for example be applied to an 8 or 16-bit analog-to-digital converter.

**Claims**

1. An analog-to-digital converter for converting an analog input voltage ($V_{in}$) to a digital output voltage signal of m more significant bits ($D_3$, $D_2$) and n less significant bits ($D_1$, $D_0$), the converter comprising:

a plurality of resistors ($R_1$ to $R_{16}$) connected in a series circuit to a voltage source ($V_r$) for establishing respective reference voltages;

more and less significant bit comparators ($M_1$ to $M_3$, $N_1$ to $N_3$) for comparing said reference voltages with said analog input voltage ($V_{in}$) to provide respective outputs ($P_1$ to $P_3$, $Q_1$ to $Q_3$) encoded as said more significant and less significant bits ($D_3$ to $D_0$) of the digital output voltage signal, said more significant bit comparators ($M_1$ to $M_3$) having first inputs all receiving said analog input voltage ($V_{in}$) and second inputs connected to said series circuit at respective intervals defining groups of said resistors ($R_1$ to $R_{16}$) therebetween, the outputs ($P_1$ to $P_3$) of said more significant bit comparators ($M_1$ to $M_3$) being encoded as said more significant bits ($D_3$, $D_2$) of the digital output voltage signal in a more significant bit encoder (ENCM); and

said less significant bit comparators ($N_1$ to $N_3$) having first inputs also all receiving said analog input voltage ($V_{in}$) and second inputs connected to said groups of resistors ($R_1$ to $R_{16}$), said outputs ($Q_1$ to $Q_3$) of said less significant bit comparators ($N_1$ to $N_3$) being supplied to a less significant bit encoder (ENCN) for encoding as said less significant bits ($D_1$, $D_0$) of the digital output voltage signal;

characterised by:

switch elements ($Q_{11}$ to $Q_{43}$) arranged in groups, said switch elements in each group having first terminals connected to respective points between the resistors ($R_1$ to $R_{16}$) of a corresponding one of said groups of resistors ($R_1$ to $R_{16}$) and second terminals connected to the second inputs of respective ones of said less significant bit comparators ($N_1$ to $N_3$); and

said more significant bit encoder (ENCM) further generating switch control signals ($B_1$ to $B_4$) which actuate said switch elements of a selected said group of the switch elements ($Q_{11}$ to $Q_{43}$) to be conductive, the switch elements of the other said groups of switch elements ($Q_{11}$ to $Q_{43}$) then being non-conductive, the actuated said group of the switch elements ($Q_{11}$ to $Q_{43}$) being selected in dependence on the values of said more significant bits.

2. An analog-to-digital converter according to claim 1 wherein said resistors ($R_1$ to $R_{16}$) are arranged in a zig-zag pattern, and said more significant bit encoder (ENCM) generates an inverting control signal ($S_0$); and further comprising a circuit for supplying said inverting control signal ($S_0$) to said less significant bit encoder (ENCN).

3. An analog-to-digital converter according to claim 1 wherein there are at least $2^{m+n}-1$ said resistors ($R_1$ to $R_{16}$) connected in series.

4. An analog-to-digital converter according to claim 1 or claim 3 wherein there are at least $2^m-1$ more significant bit comparators ($M_1$ to $M_3$).

5. An analog-to-digital converter according to claim 1, claim 3 or claim 4 wherein there are at least $2^n-1$ less significant bit comparators ($N_1$ to $N_3$).

6. An analog-to-digital converter according to any one of claims 1 and 3 to 5 wherein each of said groups of resistors ($R_1$ to $R_4$, $R_5$ to $R_8$, $R_9$ to $R_{12}$, $R_{13}$ to $R_{16}$) is $2^n$ resistors ($R_1$ to $R_{16}$).

7. An analog-to-digital converter according to any one of claims 1 and 3 to 6 wherein said resistors ($R_1$ to $R_{16}$) are arranged in parallel rows, with each of said groups ($R_1$ to $R_4$, $R_5$ to $R_8$, $R_9$ to $R_{12}$, $R_{13}$ to $R_{16}$) forming one of said rows.

8. An analog-to-digital converter according to any one of claims 1 and 3 to 5 wherein the number of said more significant bit comparators ($M_1$ to $M_3$) equals the number of said less significant bit comparators ($N_1$ to $N_3$).

9. An analog-to-digital converter according to claim 1 wherein said switch elements ($Q_{11}$ to $Q_{43}$) are metal oxide semiconductor field effect transistors.

10. An analog-to-digital converter according to claim 10 wherein said resistors ($R_1$ to $R_{16}$) are formed on a semiconductor chip.

11. An analog-to-digital converter according to claim 11 wherein said resistors ($R_1$ to $R_{16}$) are formed in a zig-zag pattern on said semiconductor chip.

**Patentansprüche**

1. Analog/Digital-Umsetzer zur Umsetzung einer analogen Eingangsspannung ($V_{in}$) in ein digitales Ausgangsspannungssignal mit m höherwertigen Bits ($D_3$, $D_2$) und n niedrigerwertigen Bits ($D_1$, $D_0$),

mit mehreren Widerständen ($R_1$ bis $R_{16}$), die zur Erzeugung entsprechender Referenzspannungen in Reihenschaltung mit einer Spannungsquelle ($V_r$) verbunden sind,

mit Komparatoren ($M_1$ bis $M_3$, $N_1$ bis $N_3$) für die höherwertigen bzw. die niedrigerwertigen Bits zum Vergleichen der Referenzspannungen mit der analogen Eingangsspannung ($V_{in}$) und zur

Erzeugung entsprechender Ausgangssignale ($P_1$ bis $P_3$, $Q_1$ bis $Q_3$), die als die genannten höherwertigen oder niedrigerwertigen Bits ($D_3$ bis $D_0$) des digitalen Ausgangsspannungssignals codiert sind,

wobei die Komparatoren ($M_1$ bis $M_3$) für die höherwertigen Bits erste Eingänge, die sämtlich die analoge Eingangsspannung ($V_{in}$) empfangen, und zweite Eingänge aufweisen, die in der Reihenschaltung an Intervallen angeschlossen sind, die jeweils Gruppen der Widerstände ($R_1$ bis $R_{16}$) zwischen sich definieren, und die Ausgangssignale ($P_1$ bis $P_3$) der Komparatoren ($M_1$ bis $M_3$) für die höherwertigen Bits in einem Codierer (ENCM) für die höherwertigen Bits als die höherwertigen Bits ($D_3$, $D_2$) des digitalen Ausgangsspannungsignals codiert sind,

und wobei die Komparatoren ($N_1$ bis $N_3$) für die niedrigerwertigen bits ebenfalls erste Eingänge, die sämtlich die analoge Eingangsspannung ($V_{in}$) empfangen, sowie zweite Eingänge aufweisen, die mit den Gruppen von Widerständen ($R_1$ bis $R_{16}$) verbunden sind, wobei die Ausgangssignale ($Q_1$ bis $Q_3$) der Komparatoren ($M_1$ bis $N_3$) für die niedrigerwertigen Bits einem Codierer (ENCN) für die niedrigerwertigen Bits zugeführt werden, der zu deren Codierung als die niedrigerwertigen Bits ($D_1$, $D_0$) der digitalen Ausgangsspannungssignal dient,

dadurch gekennzeichnet,

daß in Gruppen angeordnete Schaltelemente ($Q_{11}$ bis $Q_{43}$) vorgesehen sind, die in jeder Gruppe erste Anschlüsse, die mit entsprechenden Punkten zwischen den Widerständen ($R_1$ bis $R_{16}$) einer jeweils zugeordneten Gruppe von Widerständen ($R_1$ bis $R_{16}$) verbunden sind, sowie zweite Anschlüsse aufweisen, die mit den zweiten Eingängen der jeweils zugeordneten Komparatoren ($N_1$ bis $N_3$) für die niedrigerwertigen Bits verbunden sind,

und daß der Codierer (ENCM) für die höherwertigen Bits ferner Schaltsteuersignale ($B_1$ bis $B_4$) erzeugt, die die Schaltelemente einer ausgewählten Gruppe von Schaltelementen ($Q_{11}$ bis $Q_{43}$) in den leitenden Zustand steuern, wobei dann die Schaltelemente der jeweils anderen Gruppen von Schaltelementen ($Q_{11}$ bis $Q_{43}$) nichtleitend sind und wobei die in den leitenden Zustand gesteuerte Gruppe von Schaltelementen ($Q_{11}$ bis $Q_{43}$) abhängig von den Werten der höherwertigen Bits ausgewählt ist.

2. Analog/Digital-Umsetzer nach Anspruch 1, bei dem die genannten Widerstände ($R_1$ bis $R_{16}$) zick-zack-förmig angeordnet sind und der Codierer (ENCM) für die höherwertigen Bits ein invertierendes Steuersignal ($S_0$) erzeugt, und bei dem ferner eine Schaltung zur Zuführung dieses invertierenden Steuersignals ($S_0$) zu dem Codierer (ENCN) für die niedrigerwertigen Bits vorgesehen ist.

3. Analog/Digital-Umsetzer nach Anspruch 1, bei dem wenigstens $2^{m+n}-1$ Widerstände reihengeschaltet sind.

4. Analog/Digital-Umsetzer nach Anspruch 1 oder 3, bei dem wenigstens $2^m-1$ Komparatoren ($M_1$ bis $M_3$) für die höherwertigen Bits vorgesehen sind.

5. Analog/Digital-Umsetzer nach Anspruch 1, 3 oder 2, bei dem wenigstens $2^n-1$ Komparatoren ($N_1$ bis $N_3$) für niedrigerwertigen Bits vorgesehen sind.

6. Analog/Digital-Umsetzer nach einem der Ansprüche 1 und 3 bis 5, bei dem jede der Gruppen von Widerständen ($R_1$ bis $R_4$, $R_5$ bis $R_8$, $R_9$ bis $R_{12}$, $R_{13}$ bis $R_{16}$) aus $2^n$ Widerständen ($R_1$ bis $R_{16}$) besteht.

7. Analog/Digital-Umsetzer nach einem der Ansprüche 1 und 3 bis 6, bei dem die Widerstände ($R_1$ bis $R_{16}$) in parallelen Reihen angeordnet sind, wobei jede der Gruppen ($R_1$ bis $R_4$, $R_5$ bis $R_8$, $R_9$ bis $R_{12}$, $R_{13}$ bis $R_{16}$) eine dieser Reihen bildet.

8. Analog/Digital-Umsetzer nach einem der Ansprüche 1 und 3 bis 5, bei dem die Anzahl der Komparatoren ($M_1$ bis $M_3$) für die höherwertigen Bits gleich der Anzahl der Komparatoren ($M_1$ bis $N_3$) für die niedrigerwertigen Bits ist.

9. Analog/Digital-Umsetzer nach Anspruch 1, bei dem die Schaltelemente ($Q_{11}$ bis $Q_{43}$) MOS-FETs sind.

10. Analog/Digital-Umsetzer nach Anspruch 10, bei dem die Widerstände ($R_1$ bis $R_{16}$) auf einem Halbleiterchip ausgebildet sind.

11. Analog/Digital-Umsetzer nach Anspruch 11, bei dem die Widerstände ($R_1$ bis $R_{16}$) auf dem Halbleiterchip in einem Zick-Zack-Muster angeordnet sind.

**Revendications**

1. Convertisseur analogique-numérique destiné à convertir une tension analogique d'entrée ($V_{in}$) en un signal de tension numérique de sortie de m bits les plus significatifs ($D_3$, $D_2$) et n bits moins significatifs ($D_1$, $D_0$), le convertisseur comportant: plusieurs résistances ($R_1$ à $R_{16}$) connectées en un circuit en série à une source de tension ($V_r$) pour établir des tensions de référence respectives; des comparateurs de bits plus et moins significatifs ($M_1$ à $M_3$, $N_1$ à $N_3$) destinés à comparer lesdites tensions de références avec ladite tension analogique d'entrée ($V_{in}$) pour produire des sorties respectives ($P_1$ à $P_3$, $Q_1$ à $Q_3$) codées comme lesdits bits les plus significatifs et les moins significatifs ($D_0$ à $D_3$) du signal de tension numérique de sortie, lesdits comparateurs de bits les plus significatifs ($M_1$ à $M_3$) ayant des premières entrées qui reçoivent toutes ladite tension analogique d'entrée ($V_{in}$) et des secondes entrées connectées audit circuit en série à des intervalles respectifs définissant des groupes desdites résistances ($R_1$ à $R_{16}$) entre eux, les sorties ($P_1$ à $P_3$) des comparateurs des bits les plus significatifs ($M_1$ à $M_3$) étant codées comme les bits les plus significatifs ($D_3$, $D_2$) du signal de tension numérique de sortie dans un codeur de bits les plus significatifs (ENCM); et lesdits comparateurs de bits les moins significatifs ($N_1$ à $N_3$) ayant des premières entrées qui reçoivent toutes également ladite tension analogique d'entrée ($V_{in}$) et des secondes entrées connectées auxdits groupes de résistances ($R_1$ à

$R_{16}$), lesdites sorties ($Q_1$ à $Q_3$) desdits comparateurs de bits les moins significatifs ($N_1$ à $N_3$) étant appliquées à un codeur de bits les moins significatifs (ENCN) pour coder lesdits bits les moins significatifs ($D_1$, $D_0$) du signal de tension numérique de sortie; caractérisé en ce que des éléments de commutation ($Q_{11}$ à $Q_{43}$) sont agencés en groupes, lesdits éléments de commutation de chaque groupe ayant des premières bornes connectées à des points respectifs entre les résistances ($R_1$ à $R_{16}$) de l'un correspondant desdits groupes de résistances ($R_1$ à $R_{16}$) et des secondes bornes connectées aux secondes entrées de certains respectifs desdits comparateurs de bits les moins significatifs ($N_1$ à $N_3$); et ledit codeur de bits les plus significatifs (ENCM) produisant en outre des signaux de commande de commutation ($B_1$ à $B_4$) qui actionnent lesdits éléments de commutation d'un groupe sélectionné des éléments de commutation ($Q_{11}$ à $Q_{43}$) pour qu'il soit conducteur, les éléments de commutation de l'autre des groupes d'éléments de commutation ($Q_{11}$ à $Q_{43}$) étant non conducteur, le groupe actionné desdits éléments de commutation ($Q_{11}$ à $Q_{43}$) étant sélectionné en fonction des valeurs desdits bits les plus significatifs.

2. Convertisseur analogique-numérique selon la revendication 1, dans lequel lesdites résistances ($R_1$ à $R_{16}$) sont agencées en une configuration en zig-zag, ledit codeur de bits les plus significatifs (ENCM) produisant un signal de commande d'inversion ($S_0$); et comportant en outre un circuit pour fournir ledit signal de commande d'inversion ($S_0$) audit codeur de bits les moins significatifs (ENCN).

3. Convertisseur analogique-numérique selon la revendication 1, comportant au moins ($2^{m+n}-1$) desdites résistances ($R_1$ à $R_{16}$) connectées en série.

4. Convertisseur analogique-numérique selon la revendication 1 ou la revendication 3, comportant au moins ($2^m-1$) comparateurs de bits plus significatifs ($M_1$ à $M_3$).

5. Convertisseur analogique-numérique selon la revendication 1, la revendication 3 ou la revendication 4, comportant au moins ($2^n-1$) comparateurs de bits moins significatifs ($N_1$ à $N_3$).

6. Convertisseur analogique-numérique selon l'une quelconque des revendications 1, 3 et 5, dans lequel chacun desdits groups de résistances ($R_1$ à $R_4$, $R_5$ à $R_8$, $R_9$ à $R_{12}$, $R_{13}$ à $R_{16}$) comporte ($2^n$) résistances ($R_1$ à $R_{16}$).

7. Convertisseur analogique-numérique selon l'une quelconque des revendications 1 et 3 à 6 dans lequel lesdites résistances ($R_1$ à $R_{16}$) sont disposées en rangées parallèles, chacun desdits groupes ($R_1$ à $R_4$, $R_5$ à $R_8$, $R_9$ à $R_{12}$, $R_{13}$ à $R_{16}$) formant l'une desdites rangées.

8. Convertisseur analogique-numérique selon l'une quelconque des revendications 1 et 3 à 5 dans lequel le nombre desdits comparateurs de bits les plus significatifs ($M_1$ à $M_3$) est égal au nombre desdits comparateurs de bits les moins significatifs ($N_1$ à $N_3$).

9. Convertisseur analogique-numérique selon la revendication 1, dans lequel lesdits éléments de commutation ($Q_{11}$ à $Q_{43}$) sont des transistors à effet de champ à métal-oxyde-semi-conducteur.

10. Convertisseur analogique-numérique selon la revendication 10, dans lequel lesdites résistances ($R_1$ à $R_{16}$) sont formées sur une pastille semi-conductrice.

11. Convertisseur analogique-numérique selon la revendication 11 dans lequel lesdites résistances ($R_1$ à $R_{16}$) sont formées à une configuration en zig-zag sur ladite pastille semi-conductrice.

FIG. 1 (PRIOR ART)

F I G. 2
(PRIOR ART)

FIG. 3A

FIG. 3B

FIG. 3C

ENCODER ~ENCM

ENCODER

ENCN

0 070 175

## FIG. 4

| P₁ | P₂ | P₃ | B₁ | B₂ | B₃ | B₄ | S₀ | D₃ | D₂ |
|----|----|----|----|----|----|----|----|----|----|
| 0 | 0 | 0 | 1 | 0 | 0 | 0 | 0 | 0 | 0 |
| 1 | 0 | 0 | 0 | 1 | 0 | 0 | 1 | 0 | 1 |
| 1 | 1 | 0 | 0 | 0 | 1 | 0 | 0 | 1 | 0 |
| 1 | 1 | 1 | 0 | 0 | 0 | 1 | 1 | 1 | 1 |

① → row 2, ② → row 3

## FIG. 5

| S₀ | Q₁ | Q₂ | Q₃ | D₁ | D₀ |
|----|----|----|----|----|----|
| 0 | 0 | 0 | 0 | 0 | 0 |
| 0 | 1 | 0 | 0 | 0 | 1 |
| 0 | 1 | 1 | 0 | 1 | 0 |
| 0 | 1 | 1 | 1 | 1 | 1 |
| 1 | 0 | 0 | 0 | 0 | 0 |
| 1 | 0 | 0 | 1 | 0 | 1 |
| 1 | 0 | 1 | 1 | 1 | 0 |
| 1 | 1 | 1 | 1 | 1 | 1 |

② → row 2, ① → row 7